# EUROPEAN PATENT SPECIFICATION

(11) **EP 3 907 455 B1**
(45) Date of publication and mention of the grant of the patent: **06.12.2023**
(21) Application number: 19913347.1
(22) Date of filing: 17.12.2019
(51) Int. Cl.: F28D 15/02, F28F 3/12, H01L 23/427

(54) **PHASE-CHANGE HEAT DISSIPATION DEVICE**
WÄRMEABGEBENDE PHASENWECHSELVORRICHTUNG
DISPOSITIF DE TRANSFERT THERMIQUE À CHANGEMENT DE PHASE

(30) Priority: 29.01.2019 CN 201910086904
(43) Date of publication of application: 10.11.2021
(73) Proprietor: Smarth Technology Ltd., Zhuzhou, Hunan 412000 (CN)
(72) Inventor: LI, Chun, Zhuzhou, Hunan 412000 (CN); HU, Guangfan, Zhuzhou, Hunan 412000 (CN); YAO, Chunhong, Zhuzhou, Hunan 412000 (CN); MA, Qiucheng, Zhuzhou, Hunan 412000 (CN)
(74) Representative: Groth & Co. KB
(86) International application number: PCT/CN2019/125968
(87) International publication number: WO 2020/155899

(56) References cited:
- CN-A- 1 564 322
- CN-A- 1 869 574
- CN-A- 102 506 600
- CN-A- 102 792 119
- CN-A- 107 782 189
- CN-A- 109 612 314
- CN-A- 109 612 315
- CN-U- 202 485 512
- CN-U- 202 485 512
- CN-U- 202 799 543
- CN-U- 206 131 833
- CN-U- 209 745 070
- CN-U- 209 877 718
- CN-Y- 2 720 631
- DE-A1- 10 333 877
- JP-A- S6 417 457
- US-A- 6 062 299
- US-A1- 2004 154 785
- US-A1- 2007 025 085
- US-A1- 2008 105 404
- US-A1- 2016 003 555
- US-A1- 2017 314 870
- US-B1- 6 230 788
- US-B1- 6 237 223

## Description

### Technical field

The present invention pertains to the technical field of phase-change heat dissipation devices, and is particularly related to a phase-change heat dissipation device with high heat flux density.

### Background

With the high-speed development of the Internet and IOT, the data processing speed requirement of desktop PCs, notebooks, servers, and other computational devices increases continuously, while at the same time the data storage capacity also increases drastically. Due to the continuously increasing power loss of the CPU and the memory used in these computational devices, the heat flux density of the heat dissipation devices thereof is required to be increasingly high. Since the power density of CPUs and memory are becoming increasingly large and the heat flux density of the heat dissipation devices thereof are becoming increasingly high, traditional heat pipes are limited by factors such as the heat pipe inner diameter and the phase-change heat exchange medium, and their heat dissipation capacity is unable to meet the requirements for the technical development of CPUs and memory.

Traditional copper-water heat pipes and ordinary finned heat dissipation devices cannot meet the heat dissipation requirement, and 3D phase-change heat dissipation devices or liquid cooling heat dissipation devices with higher heat flux density have to be used. A liquid cooling heat dissipation device needs peripheral equipment such as a liquid cooling device and an external heat exchanger, with high cost and complicated maintenance requirements. Direct manufacturers of CPUs are seeking breakthrough in the heat dissipation technology, some of them are starting to try liquid cooling heat dissipation devices, but in consideration that the liquid cooling heat dissipation device need complicated internal ancillary equipment such as a liquid cold source, a liquid dispenser and a quick coupler, as well as complicated external heat exchanging equipment on the outside, and that risks of leakage of liquid cold medium would influence the safety of the operating devices, liquid cooling heat dissipation devices are far from being popularized.

In existing heat dissipation devices, several pieces of heat pipes are provided in a base plate and are bent to different profiles. The existing heat dissipation devices mainly have the following problems and defects:
Firstly, due to the constraint of heat transfer limit of heat pipes, for an existing CPU of 45mm*69mm, a maximum of 3-4 heat pipes each having a diameter of Φ 6 can be arranged. The processing technique of heat pipes is already very fine and mature, and even so, a single Φ6 heat pipe can only reach a heat transfer limit of 40W due to its capillary force limitation. Therefore, the existing heat-pipe heat dissipation device cannot meet the requirement for heat dissipation of CPUs with a heat flux density higher than 600J/(m² • s). Meanwhile, the increase of heat dissipation airflow has very limited effect on the thermal resistance of the heat dissipation device, and along with the increase of airflow, the temperature difference between the bottom part and the top part of the aluminum fins would be increased, and the actual effective area of the heat dissipation device would be reduced, so the thermal resistance of the heat dissipation device can only be reduced to a very limited extent Therefore, the thermal resistance of conventional heat-pipe heat dissipation devices normally cannot be lower than 0.016K/W, and thus, under a condition that the ambient temperature is 30°C, the surface temperature of the CPU would be higher than 62°C.
Secondly, the heat pipes are normally copper pipes that utilize phase-change of deionized water to realize temperature equalization within the heat pipes. As limited by the distribution of heat pipes, not only the temperature equalization of the base plate surface in contact with the CPU cannot be fully realized, but also the temperature equalization of the aluminum ceramic sheets in direct contact with the cooling air cannot be realized. As heat is ultimately transferred to the cooling air through the aluminum ceramic sheets, the conventional heat pipes have very limited enhancement on the performance of the heat dissipation device.

Finally, most of the existing heat pipe shells are made of red copper, and most of the base plates are made of aluminum alloy, and low-temperature tin brazing or cementing is usually adopted to fill the gaps after the heat pipes and the base plate are formed. The disadvantages of low temperature tin brazing include: surface treatment such as integral nickel plating or copper plating must be performed on the heat dissipation device before brazing, the surface treatment and the brazing lead to high cost and pollution to the environment; it is difficult for the brazing to ensure that the interface between the heat pipes and the aluminum alloy base plate is sufficiently filled without any remaining local gap, and as the heat pipes are located below the power device which has a high heat flux density, any gap therein would cause local temperature rise of the CPU, resulting in damage to the device. A phase-change heat dissipation device according to the preamble of claim 1 is disclosed in US 2008/105404 A1.

### Summary of the invention

To solve the problems in the prior art as described above, the present invention provides a phase-change heat dissipation device to improve the heat transfer efficiency for promotion of fast dissipation of heat.

In order to achieve the above objective, the specific technical scheme of the phase-change heat dissipation device of the present invention is as follows:
A phase-change heat dissipation device comprises a phase-change assembly internally provided with a phase-change heat exchange medium, wherein the phase-change assembly comprises an evaporator part and a condenser part, the evaporator part has an evaporation chamber therein, the condenser part has a condensation chamber therein, the evaporation chamber is communicated with the condensation chamber, and a heat source is in direct contact with the evaporation chamber, the phase-change heat exchange medium inside the evaporation chamber is configured to absorb heat from the heat source and transfer the heat to the condensation chamber, and the condensation chamber is configured to radiate heat outwards, so as to cool the heat source.

Furthermore, the evaporation chamber is a planar, curved or polyhedral chamber and is matched with a shape of the heat source so as to increase a contact area between the heat source and the evaporation chamber.

Furthermore, the evaporation chamber is a thin-walled chamber, a working pressure in the evaporation chamber is a positive pressure, and a contact surface of the evaporation chamber in contact with the heat source can generate elastic deformation so as to improve the contact effect between the heat source and the evaporation chamber.

Furthermore, the condensation chamber is directly connected to the evaporation chamber, or is connected to the evaporation chamber through a connecting pipeline.

Furthermore, the condenser part comprises a plurality of condensation support plates, and the condensation chamber comprises a planar chamber correspondingly arranged inside each of the condensation support plates; or the condenser part comprises a plurality of condensation branch pipes, and the condensation chamber comprises a cylindrical chamber correspondingly arranged inside each of the condensation branch pipes; or the condenser part comprises a plurality of condensation conical pipes, and the condensation chamber comprises a conical chamber correspondingly arranged inside each of the condensation conical pipes.

Furthermore, multiple ribs, bumps or fins are arranged inside the evaporator part and/or the condenser part to increase the pressure bearing capability.

Furthermore, the evaporator part is provided with a mounting rack, and the heat source is connected with the evaporator part through the mounting rack.

Furthermore, the condenser part further comprises a condensation top plate, a planar condensation chamber or a curved condensation chamber is formed inside the condensation top plate, and the part of condensation chamber inside the condensation top plate is communicated with the part of condensation chamber inside the condensation support plates, the condensation branch pipes or the condensation conical pipes.

Furthermore, the phase-change heat dissipation device further comprises cooling fins connected with the condenser part.

Furthermore, the cooling fins are connected to an external surface of each of the condensation support plates in a brazed manner, and the condensation chamber radiates heat outwards through the cooling fins so as to cool the heat source.

The phase-change heat dissipation device of the present invention has the following advantages:
1) The phase-change assembly is in direct contact with the heat source, no transitional heat conduction plate is needed, the temperature difference between the heat source and the phase-change assembly would be lower;
2) The external profile of the evaporator part of the phase-change assembly is matched with the heat source in shape. If the heat source has a planar structure, the evaporation chamber would be a planar thin-walled chamber; if the heat source has a curved-surface-shaped structure, the evaporation chamber would be a curved-surface thin-walled chamber; if the heat source has multiple surfaces in contact with the phase-change heat dissipation device, the evaporation chamber can also be a polyhedral thin-walled chamber. The purpose is to ensure that the contact area between the heat source and the phase-change heat dissipation device is always maximized, so the temperature difference between the phase-change heat exchange medium in the evaporation chamber and the heat source would be minimized.
3) The evaporator part of the phase-change assembly is in contact with the heat source, and the interior of the evaporation chamber is in a positive pressure state (higher than atmosphere pressure), not in a negative pressure or micro-positive pressure state (lower or close to atmosphere pressure) as in a traditional phase-change device. Along with the increase of heat flux density of the heat source, the working pressure inside the evaporation chamber increases continuously, and since the contact surface of the evaporation chamber in contact with the heat source has a thin-walled structure, when the pressure inside the evaporation chamber increases, the phase-change assembly can be in sufficient contact with the heat source, with closer abutting and better heat transfer effect, and when the heat flux density of the heat source is large, evaporation of the phase-change heat exchange medium can realize a rapid heat diffusion in the evaporator part of the phase-change assembly, so the temperature difference throughout the evaporator part would be very small.
4) The phase-change assembly has a three-dimensional heat dissipation structure, and after the phase-change heat exchange medium evaporates, the vapor thereof can quickly diffuse to any low-temperature site of the phase-change assembly (the phase-change heat exchange medium condenses at the low-temperature site, and lower pressure occurs), so that the phase-change assembly has equalized temperature, the heat transfer has high efficiency and uniformity.

Besides the above advantages, surface treatment processes (nickel plating or copper plating) will not be needed for manufacturing the phase-change heat dissipation device of the present invention, the phase-change assembly and the cooling fins of the heat dissipation device are directly welded into a whole by high-temperature brazing, a heating source (such as a power device CPU) makes contact with the phase-change heat dissipation device, then low-temperature tin soldering is applied to avoid gaps, and thus the heat transfer limit of the phase-change heat dissipation device of the present invention is remarkably increased (far greater than 200W).

The phase-change heat dissipation device of the present invention can be applied to various power electronic components such as chips, resistors, capacitors, inductors, storage media, light sources and battery packs for heat dissipation.

### Brief description of the drawings

Fig. 1a is a perspective view of a first embodiment of the phase-change heat dissipation device of the present invention;
Fig. 1b is a cross-sectional view of the phase-change heat dissipation device of Fig. 1a;
Fig. 2 is a perspective view of a second embodiment of the phase-change heat dissipation device of the present invention;
Fig.3a is a perspective view of a third embodiment of the phase-change heat dissipation device of the present invention;
Fig. 3b is a cross-sectional view of the phase-change heat dissipation device of Fig. 3a;
Fig. 4a is a perspective view of a fourth embodiment of the phase-change heat dissipation device of the present invention;
Fig. 4b is a cross-sectional view of the phase-change heat dissipation device of Fig. 4a;
Figures 5-6 show schematic diagrams of the flow of the phase-change heat exchange medium in the phase-change assembly of the present invention;
Fig. 7a is a perspective view of a fifth embodiment of the phase-change heat dissipation device of the present invention. In this device, the evaporator part and the condenser part are arranged separately and connected to each other through pipes, the evaporator part has a rectangular hollow chamber, while the condenser part has several condensation support plates;
Fig. 7b is a cross-sectional view of the phase-change heat dissipation device of Fig. 7a;
Fig. 8a is a perspective view of a sixth embodiment of the phase-change heat dissipation device of the present invention. In this device, the evaporator part and the condenser part are arranged separately and connected to each other through pipes, the evaporator part has a rectangular hollow chamber, while the condenser part has several condensation branch pipes,
with multiple cylindrical chambers inside the condensation branch pipes;
Fig. 8b is a cross-sectional view of the phase-change heat dissipation device of Fig. 8a;
Fig. 9a is a front view of a seventh embodiment of the phase-change heat dissipation device of the present invention. In this device, several condensation support plates are communicated with each other;
Fig. 9b is a cross-sectional view of the phase-change heat dissipation device of Fig. 9a. In this device, several condensation support plates are communicated with each other through a condensation top plate;
Fig. 9c is a perspective view of the phase-change device of Fig. 9a, in which the evaporator part has a curved structure and the heat source is wrapped by the evaporator part of the phase-change heat dissipation device.
Fig. 10a is a cross-sectional view of an eighth embodiment of the phase-change heat dissipation device of the present invention;
Fig. 10b is a perspective view of the phase-change heat dissipation device of Fig. 10a.

### Detailed description of embodiments

In order to better understand the purpose, the structure and the function of the present invention, the phase-change heat dissipation device of the present invention is described in more details below in conjunction with the accompanying drawings.

In the present invention, the relevant terms are defined as follows:
Heat flux density: The amount of heat transferred through a unit area in a unit time is called the heat flux density, q = Q/(S*t). Here, Q is the amount of heat, t is the time, S is the cross-sectional area, and the unit of heat flux density is J/(m²•s).

Heat transfer limit: The maximum heat loading that can be transferred by a phase-change heat dissipation device (including heat pipes) is called the heat transfer limit, which is related to the size, shape, physical properties of the phase-change heat exchange medium, the working temperature, and other factors. For a traditional heat pipe, some typical limitations are the capillary force limitation, the carrying limitation, the boiling limitation, the sound velocity limitation, and the viscosity limitation, and the heat transfer capacity of the heat pipe is determined by the lowest limitation value.

Thermal conductivity: Providing that two parallel planes with a distance of 1 meter and an area of 1 square meter each are taken perpendicular to the direction of heat conduction inside an object, if the temperatures of the two planes differ by 1 K, the amount of heat conducted from one plane to the other plane in 1 second is defined as the thermal conductivity of the substance in Watt *m -¹ *K⁻¹ (W•m⁻¹•K⁻¹) .

Thermal resistance: It is defined as the ratio between the temperature difference across an object and the power of a heat source in Kelvin per Watt (K/W) or degrees Celsius per Watt (°C/W) when heat is transferred across the object.

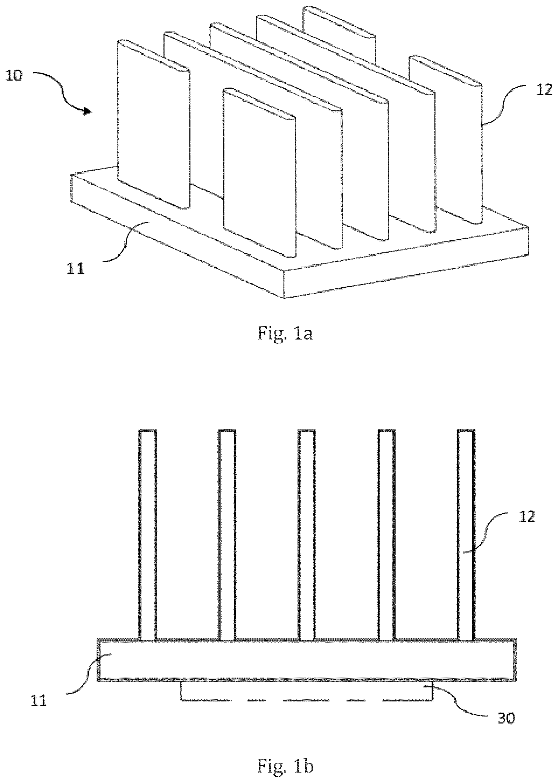

As shown in Figures 1a-10b, the phase-change heat dissipation device 10 comprises an evaporator part 11, a condenser part 12 and a phase-change heat exchange medium 20 inside the evaporator part 11 or the condenser part 12. The evaporator part 11 and the condenser part 12 jointly form a three-dimensional heat exchange structure. When the phase-change heat dissipation device 10 is working, the working pressure in the phase-change heat dissipation device 10 is higher than 0.15 MPa, the phase-change heat dissipation device 10 is in a positive pressure state, and the external surface of the evaporator part is in direct contact with a heat source.

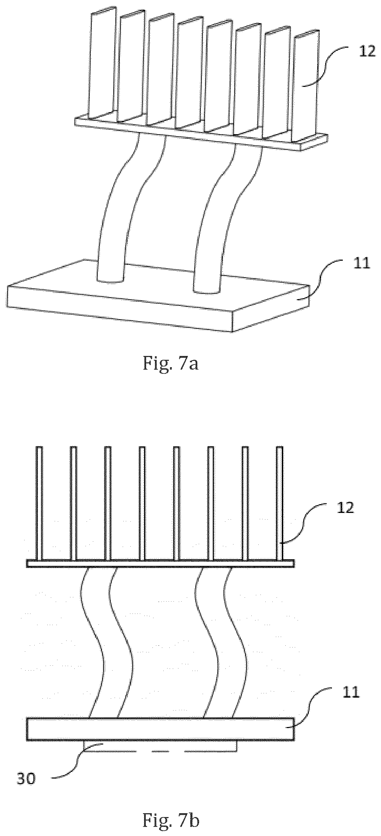

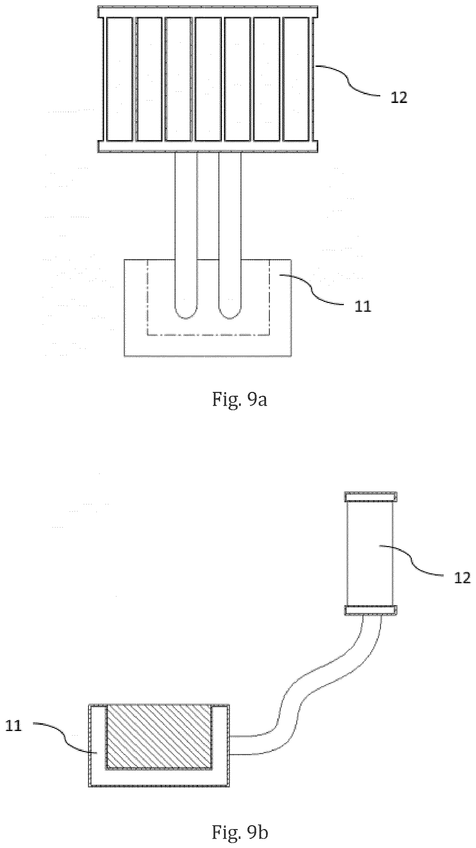

The evaporator part 11 and the condenser part 12 may be directly connected (shown in Figs. 1a-6), or may have a separated structure connected by pipes (shown in Figs. 7a-8b). In addition, the shape of the evaporator part 11 is matched with that of the heat source, the evaporation chamber can be a planar, curved or polyhedral thin-walled chamber to increase the contact area between the heat source and the external surface(s) of the evaporator part. The evaporator part 11 and the heat source have at least one appropriate contact surface, so that the evaporator part 11 and the heat source are in close contact. Therefore, the temperature difference between the heat source and the phase-change heat exchange medium in direct contact with the inner wall of the evaporation chamber is reduced (as shown in Figures 9a-10b).

Therefore, the profile of the evaporation chamber of the phase-change assembly matches the shape of the heat source. When the heat source has a planar structure, the evaporation chamber is a planar thin-walled chamber; When the heat source has a curved-surface-shaped structure, the evaporation chamber is a curved-surface thin-walled chamber; When the heat source has multiple surfaces in contact with the phase-change heat dissipation device, the evaporation chamber is a polyhedral thin-walled chamber. The present invention aims to ensure the maximum contact area between the heat source and the phase-change heat dissipation device, so as to realize the minimum temperature difference between the heat source and the phase-change heat exchange medium in the evaporation chamber.

The evaporator part of the phase-change assembly is in close contact with the heat source, and the interior of the evaporation chamber is in a positive pressure state (higher than atmosphere pressure), not in a negative pressure or micro-positive pressure state (lower or close to atmosphere pressure) as in a traditional phase-change device. Along with the increase of heat flux density of the heat source, the working pressure inside the evaporation chamber increases continuously, and since the contact surface of the evaporation chamber in contact with the heat source has a thin-walled structure, when the pressure inside the evaporation chamber increases, the phase-change assembly can be in sufficient contact with the heat source, with closer abutting and better heat transfer effect, and when the heat flux density of the heat source is large, evaporation of the phase-change heat exchange medium can realize fast heat transfer in the evaporator part of the phase-change assembly, so the temperature difference throughout the evaporator part would be very small.

As shown in Figs. 1a-1b, as a first embodiment of the present invention, a phase-change heat dissipation device 10 of the present invention comprises a phase-change assembly having a closed structure with a chamber inside, the phase-change assembly containing a phase-change heat exchange medium 20 therein, the internal chamber of the phase-change assembly having a fully-communicated structure, and the phase-change heat exchange medium 20 being capable of circulating throughout the entire internal chamber of the phase-change assembly.

The phase-change assembly comprises an evaporator part 11 and a condenser part 12, an evaporation chamber is formed in the evaporator part 11, a condensation chamber is formed in the condenser part 12, the evaporation chamber of the evaporator part 11 is communicated with the condensation chamber of the condenser part 12, the evaporation chamber and the condensation chamber form the internal chamber of the phase-change assembly, and the condenser part 12 is joint with cooling fins. The phase-change heat exchange medium 20 in the evaporation chamber absorbs heat from the heat source 30 and then vaporizes and flows into the condensation chamber to be cooled and liquefied, and the condensation chamber radiates heat outwards through the cooling fins. Therefore, the phase-change heat dissipation device 10 can transfer heat of the heat source 30 to air or other gaseous cooling media to achieve the effect of heat dissipation and cooling of the heat source.

The evaporator part 11 of the phase-change assembly is a planar plate-shaped body or a curved plate-shaped body with a chamber inside, a planar evaporation chamber or a curved-surface-shaped evaporation chamber is formed inside the evaporation part 11, and the planar chamber or the curved-surface-shaped chamber inside the evaporation part 11 is communicated with the condensation chamber inside the condenser part 12.

The condenser part 12 comprises a plurality of condensation support plates with chambers inside, the interiors of the condensation support plates are planar condensation chambers, several condensation plates are connected to the evaporator part 11, and the planar condensation chambers inside the condensation support plates are communicated with the planar evaporation chamber or the curved evaporation chamber inside the evaporator part 11. The condensation support plates are preferably arranged in parallel in rows, the condensation support plates are perpendicularly connected to the evaporator part 11, the external sides of the condensation support plates are connected with cooling fins, and heat in the condensation support plates is radiated to the outside through the cooling fins.

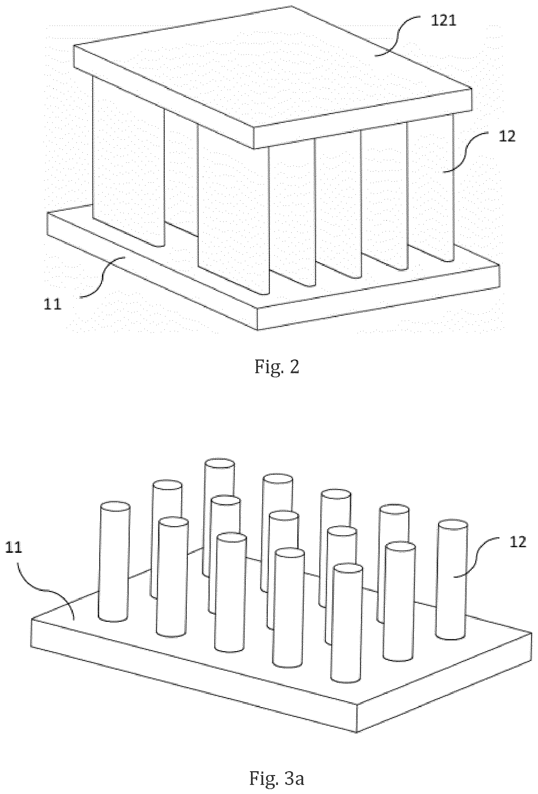

Further, as shown in figure 2, the condenser part 12 further comprises a condensation top plate 121, a planar condensation chamber or a curved condensation chamber is formed in the condensation top plate 121, the part of condensation chamber in the condensation top plate 121 is connected with the part of condensation chamber in the condensation support plates, and the whole condenser part 12 is in a comb shape. The phase-change heat exchange medium 20 absorbs heat in the evaporation chamber of the evaporator part 11, heat is dissipated through the condensation support plates and the condensation top plate 121 of the condenser part 12, and the phase-change heat exchange medium 20 circularly flows in the evaporation chamber of the evaporator part 11 and the condensation chamber in the condensation support plates and the condensation top plate 121 so as to dissipate heat of the heat source 30. The condensation top plate 121 may be integrally formed with the condensation support plates. The evaporator part 11 and the condensation part 12 of the phase-change assembly are also preferably integrally formed.

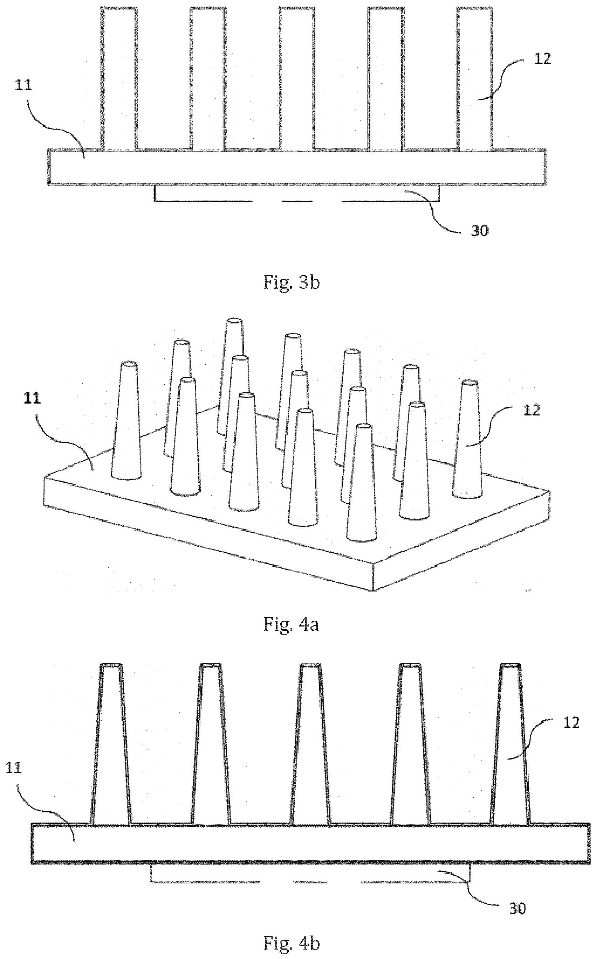

As shown in Figures 3a-3b, in this embodiment, the condensation support plates in the condensation part 12 take other forms, that is, the condensation part 12 comprises a plurality of cylindrical condensation branch pipes, and the condensation chamber comprises a cylindrical chamber correspondingly arranged inside each of the condensation branch pipes. As shown in Figures 4a-4b, the condenser part 12 can also comprise a plurality of condensation conical pipes, and the condensation chamber comprises a conical chamber correspondingly arranged inside each of the condensation conical pipes. In practice, the condensation support plates, the condensation branch pipes or the condensation conical pipes can be selected according to structural requirements.

The evaporator part 11 is in direct contact with the heat source 30, that is, a surface of the evaporator part 11 (an external surface of the evaporation chamber) is in direct contact with the heat source 30, and the surface of the evaporator part 11 directly replaces a substrate of an existing heat dissipation device, so that the heat transfer efficiency between the heat source 30 and the evaporator part 11 is improved. The evaporator part 11 is preferably a planar plate-shaped body with a chamber inside, one side of the evaporator part 11 is provided with a contact heat absorption surface, the heat source 30 is provided with a planar heat source surface, and the contact heat absorption surface of the evaporator part 11 is in contact with the heat source surface of the heat source 30.

The evaporator part can also be provided with a mounting rack to mount the heat source and the phase-change heat dissipation device together, and the mounting rack can fixedly connect the heat source and the evaporator part to prevent plastic deformation of the evaporator part caused by the increase of internal pressure of the evaporation chamber.

The area of the heat source surface of the heat source 30 is smaller than the area of the contact heat absorption surface of the evaporator part 11 of the phase-change assembly, and the internal phase-change heat exchange medium 20 can rapidly transfer heat from the heat source 30 along two-dimensional directions through phase-change flow, so that the temperature in the evaporation chamber of the phase-change assembly is ensured to be uniform. The vaporized phase-change heat exchange medium 20 enters the condensation support plates and flows in a third direction which is perpendicular to the evaporator part 11 having a planar plate-shaped body, i.e., perpendicular to the two-dimensional heat dissipation directions inside the evaporator part 11.

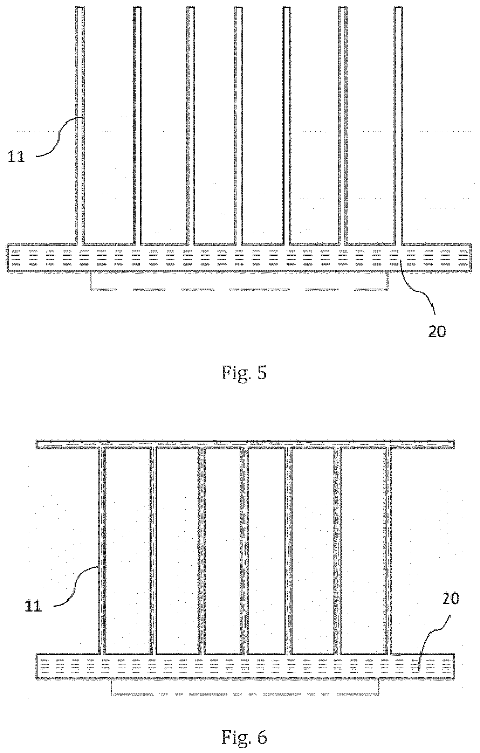

As shown in Fig. 5-6, the circulating flow condition of the phase-change heat exchange medium 20 in the phase-change assembly is displayed, the phase-change heat exchange medium 20 of the evaporator part 11 absorbs the heat of the heat source 30 and then diffuses along a two-dimensional plane in the internal evaporation chamber of the evaporator part 11, and then the phase-change heat exchange medium 20 is vaporized and flows into the condensation support plates of the condenser part 12 perpendicular to the evaporator part 11. The phase-change heat exchange medium 20 that has flowed into the condensation support plates then flows into the condensation top plate 121, cooling fins are connected to the external surfaces of the condensation support plates and the condensation top plate 121, and heat carried by the phase-change heat exchange medium 20 in the condensation support plates and the condensation top plate 121 is radiated outwards through the cooling fins, so that a more favorable heat dissipation effect and performance are obtained.

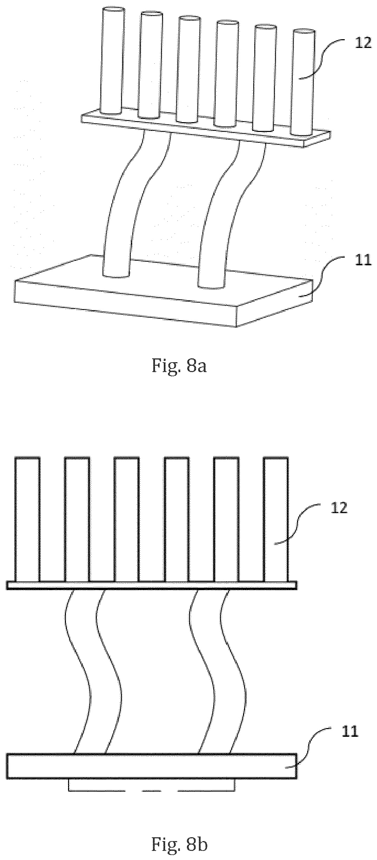

As shown in Figures 7a, 7b, 8a, 8b, in these embodiments, the condensation chamber of the condenser part 12 is not directly connected to the evaporation part 11, and the condensation chamber of the condenser part 12 is connected to the evaporation part 11 via a pipeline to facilitate a reasonable arrangement of the evaporation part 11 and the condenser part 12 according to the internal system configuration of the heat source 30. Figures 7a, 7b show a condenser part with condensation support plates, and Figures 8a, 8b show a condenser part with condensation branch pipes.

In the embodiment shown in Figures 7a-8b, since the condenser part and the evaporator part are connected by a pipeline, it is possible to flexibly arrange the condenser part and the evaporator part, respectively. For example, the condenser part 12 may be placed horizontally or vertically, and the configuration and placement orientation may be varied according to the structural design of the system in which the heat source is placed. The heat of the heat source is directly transferred to the phase-change heat exchange medium 20 through the thin wall of the evaporator part 11, the phase-change heat exchange medium 20 absorbs heat to generate phase change, so that pressure difference is generated between the evaporator part 11 and the condenser part 12 in the phase-change heat dissipation device 10, and therefore the phase-change heat exchange medium 20 is driven to flow towards the condenser part 12, and after the phase-change heat exchange medium is condensed in the condenser part 12, the phase-change heat exchange medium 20 can be transported back to the evaporator part 11 by gravity or capillary force, so that a cycle is formed.

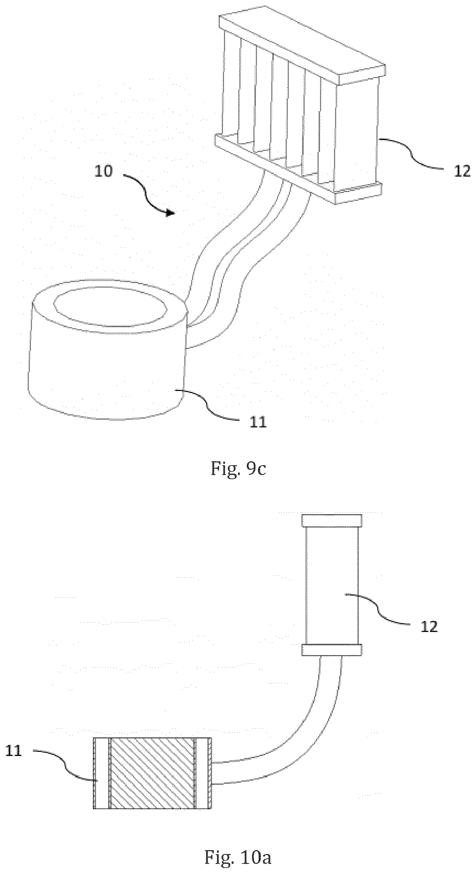

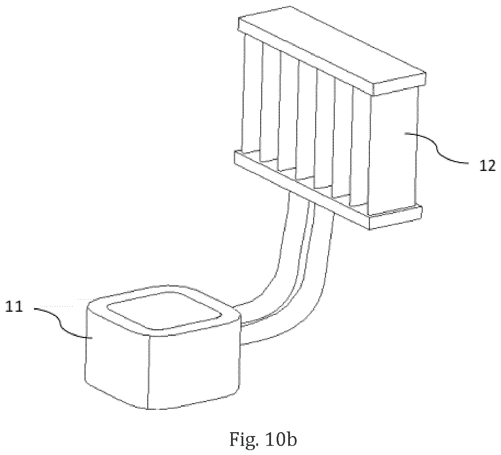

As shown in FIGS. 9a, 9b, 9c, 10a, 10b, in these embodiments, the shape of the evaporator part 11 is adapted to the shape of the heat source, the evaporation chamber can be a planar, curved or polyhedral thin-walled chamber to increase the contact area between the heat source and the external wall surface of the evaporator part, and the evaporator part 11 and the heat source have at least one contact surface suitable for fit connection, so that the evaporator part 11 and the heat source are in close contact with each other. Therefore, the temperature difference between the heat source and the phase-change heat exchange medium in direct contact with the inner wall of the evaporation chamber is reduced.

The evaporator part 11 shown in Figs. 9a, 9b and 9c is a cylindrical groove body, the evaporator part shown in Figs. 10a and 10b is a square column groove body, the heat source 30 can be directly installed in the evaporator part 11 of the phase-change assembly, and the heat source 30 and the evaporator part 11 have a plurality of contact heat exchange surfaces.

Therefore, the evaporator part 11 and the condenser part 12 of the phase-change assembly are communicated, the evaporator part 11 at one end of the phase-change assembly is directly communicated with the condenser part 12 at the other end of the phase-change assembly and in the evaporation and condensation process of the phase-change heat exchange medium 20 in the phase-change assembly, horizontal and vertical three-dimensional transfer of heat from one end of the phase-change assembly to the other end of the phase-change assembly can be achieved, and the temperature uniformity of the inner chamber of the whole phase-change assembly, especially of the condensation chamber in the condenser part 12, is improved.

Further, a plurality of ribs, bumps or fins are arranged inside the evaporator part 11 and/or the condenser part 12 to improve the pressure bearing capability.

The phase-change assembly and the cooling fins may be made of copper or aluminum, for example, the phase-change assembly and the cooling fins are both made of copper or aluminum, and the phase-change assembly and the cooling fins are preferably connected by brazing to reduce the contact thermal resistance between the phase-change assembly and the cooling fins, thereby reducing the temperature difference between the cooling fins and the heat source 30. After the heat source 30 (such as a power device CPU) and the phase-change heat dissipation device 10 (such as an evaporator part 11 thereof) are in contact connection, low-temperature tin soldering is applied to avoid gaps.

The cooling fins and the external walls of the condensation support plates are welded together, the pressure bearing capability of the condensation support plates is improved, when the heat dissipation device works, the internal working pressure of the condenser part 12 and the evaporator part 11 can be increased, and if the internal working pressure is increased to be higher than 1MPa, an interwoven structure formed by welding the cooling fins and the condensation support plates can ensure that the condenser part 12 is able to bear the strength required by working. The condenser part 12 does not deform, and normal operation of the heat dissipation device is guaranteed.

The phase-change heat dissipation device of the present invention can be applied to various power electronic devices such as a chip, a resistor, a capacitor, an inductor, a storage medium, a light source and a battery pack for heat dissipation.

It can be understood that, the present invention is described with reference to some embodiments, and as known by a person skilled in the art, without departing from the working theory and scope of the present invention, various changes and equivalent modifications can be made to these features and embodiments. And, under the guidance of the present invention, these features and embodiments can be modified to adapt to specific circumstances and materials without departing from the working theory and scope of the present invention. Therefore, the present invention is not to be limited by the particular embodiments disclosed herein, and all embodiments falling within the scope of the claims of the present application are intended to be encompassed by the protection scope of the present invention.

## Claims

1. A phase-change heat dissipation device (10), comprising a phase-change assembly internally provided with a phase-change heat exchange medium (20),
wherein the phase-change assembly comprises an evaporator part (11) and a condenser part (12), the evaporator part (11) has an evaporation chamber therein, the condenser part (12) has a condensation chamber therein, a heat source is in direct contact with the evaporation chamber in such a way that the phase-change heat exchange medium (20) in the evaporation chamber can absorb heat from the heat source, the evaporation chamber is communicated with the condensation chamber in such a way that the phase-change heat exchange medium (20) in the evaporation chamber can transfer the heat to the condensation chamber, the condensation chamber is structured to radiate heat outwards so as to cool the heat source,
wherein the evaporation chamber is a thin-walled chamber, the phase-change heat dissipation device being **characterized in that** a working pressure in the evaporation chamber is a positive pressure, and a contact surface of the evaporation chamber in contact with the heat source can generate elastic deformation so as to improve the contact effect between the heat source and the evaporation chamber.

2. The phase-change heat dissipation device (10) according to claim 1, **characterized in that** the evaporation chamber is a planar chamber matched with a planar structure of the heat source, or the evaporation chamber is a curved chamber matched with a curved-surface-shaped structure of the heat source, or the evaporation chamber is a polyhedral chamber matched with multiple surfaces of the heat source, so as to increase a contact area between the heat source and the evaporation chamber.

3. The phase-change heat dissipation device (10) according to claim 1, **characterized in that** the condensation chamber is directly connected to the evaporation chamber, or is connected to the evaporation chamber through a connecting pipeline.

4. The phase-change heat dissipation device (10) according to any one of claims 1-3, **characterized in that** the condenser part (12) comprises a plurality of condensation support plates, and the condensation chamber comprises a planar chamber correspondingly arranged inside each of the condensation support plates; or the condenser part (12) comprises a plurality of condensation branch pipes, and the condensation chamber comprises a cylindrical chamber correspondingly arranged inside each of the condensation branch pipes; or the condenser part (12) comprises a plurality of condensation conical pipes, and the condensation chamber comprises a conical chamber correspondingly arranged inside each of the condensation conical pipes.

5. The phase-change heat dissipation device according to claim 4, **characterized in that** a plurality of ribs, bumps or fins are arranged inside the evaporator part and/or the condenser part to increase the pressure bearing capability.

6. The phase-change heat dissipation device (10) according to claim 4, **characterized in that** the evaporator part (11) is provided with a mounting rack, and the heat source is connected with the evaporator part (11) through the mounting rack.

7. The phase-change heat dissipation device (10) according to claim 4, **characterized in that** the condenser part (12) further comprises a condensation top plate, a planar condensation chamber or a curved condensation chamber is formed inside the condensation top plate, and the part of condensation chamber inside the condensation top plate is communicated with the part of condensation chamber inside the condensation support plates, the condensation branch pipes of the condensation conical pipes.

8. The phase-change heat dissipation device (10) according to claim 4, **characterized in** further comprising cooling fins connected with the condenser part (12).

9. The phase-change heat dissipation device according to claim 8, **characterized in that** the cooling fins are connected to an external surface of each of the condensation support plates in a brazed manner, and the condensation chamber radiates heat outwards through the cooling fins so as to cool the heat source.

## Patentansprüche

1. Wärmeabgebende Phasenwechselvorrichtung (10), umfassend eine Phasenwechselanordnung, die im Inneren mit einem wärmeaustauschenden Phasenwechselmedium (20) versehen ist,
wobei die Phasenwechselanordnung einen Verdampferteil (11) und einen Kondensatorteil (12) umfasst, der Verdampferteil (11) eine Verdampfungskammer darin aufweist, der Kondensatorteil (12) eine Kondensationskammer darin aufweist, eine Wärmequelle in direktem Kontakt mit der Verdampfungskammer steht, sodass das wärmeaustauschende Phasenwechselmedium (20) in der Verdampfungskammer Wärme von der Wärmequelle aufnehmen kann, die Verdampfungskammer derart mit der Kondensationskammer verbunden ist, dass das wärmeaustauschende Phasenwechselmedium (20) in der Verdampfungskammer die Wärme an die Kondensationskammer übertragen kann, die Kondensationskammer derart strukturiert ist, dass sie Wärme nach außen abstrahlt, um die Wärmequelle zu kühlen,
wobei die Verdampfungskammer eine dünnwandige Kammer ist, die wärmeabgebende Phasenwechselvorrichtung **dadurch gekennzeichnet ist, dass** ein Betriebsdruck in der Verdampfungskammer ein Überdruck ist, und eine Kontaktfläche der Verdampfungskammer in Kontakt mit der Wärmequelle eine elastische Verformung erzeugen kann, um die Kontaktwirkung zwischen der Wärmequelle und der Verdampfungskammer zu verbessern.

2. Wärmeabgebende Phasenwechselvorrichtung (10) nach Anspruch 1, **dadurch gekennzeichnet, dass** die Verdampfungskammer eine planare Kammer ist, die an eine planare Struktur der Wärmequelle angepasst ist, oder die Verdampfungskammer eine gekrümmte Kammer ist, die an eine gekrümmtflächig geformte Struktur der Wärmequelle angepasst ist, oder die Verdampfungskammer eine polyedrische Kammer ist, die an mehrere Flächen der Wärmequelle angepasst ist, um eine Kontaktfläche zwischen der Wärmequelle und der Verdampfungskammer zu vergrößern.

3. Wärmeabgebende Phasenwechselvorrichtung (10) nach Anspruch 1, **dadurch gekennzeichnet, dass** die Kondensationskammer direkt mit der Verdampfungskammer verbunden ist oder über eine Verbindungsrohrleitung mit der Verdampfungskammer verbunden ist.

4. Wärmeabgebende Phasenwechselvorrichtung (10) nach einem der Ansprüche 1 bis 3, **dadurch gekennzeichnet, dass** der Kondensatorteil (12) eine Vielzahl von Kondensationsträgerplatten umfasst und die Kondensationskammer eine planare Kammer umfasst, die entsprechend innerhalb jeder der Kondensationsträgerplatten angeordnet ist; oder der Kondensatorteil (12) eine Vielzahl von Kondensationsabzweigrohren umfasst und die Kondensationskammer eine zylindrische Kammer umfasst, die entsprechend innerhalb jedes der Kondensationsabzweigrohre angeordnet ist; oder der Kondensatorteil (12) eine Vielzahl von konischen Kondensationsrohren umfasst und die Kondensationskammer eine konische Kammer umfasst, die entsprechend innerhalb jedes der konischen Kondensationsrohre angeordnet ist.

5. Wärmeabgebende Phasenwechselvorrichtung nach Anspruch 4, **dadurch gekennzeichnet, dass** zur Erhöhung der Drucktragfähigkeit im Verdampferteil und/oder im Kondensatorteil eine Vielzahl von Rippen, Erhebungen oder Lamellen angeordnet ist.

6. Wärmeabgebende Phasenwechselvorrichtung (10) nach Anspruch 4, **dadurch gekennzeichnet, dass** der Verdampferteil (11) mit einem Baugruppenträger versehen ist und die Wärmequelle durch den Baugruppenträger mit dem Verdampferteil (11) verbunden ist.

7. Wärmeabgebende Phasenwechselvorrichtung (10) nach Anspruch 4, **dadurch gekennzeichnet, dass** der Kondensatorteil (12) ferner eine Kondensationsdeckplatte, eine planare Kondensationskammer oder eine gekrümmte Kondensationskammer umfasst, die innerhalb der Kondensationsdeckplatte ausgebildet ist, und der Teil der Kondensationskammer innerhalb der Kondensationsdeckplatte mit dem Teil der Kondensationskammer innerhalb der Kondensationsträgerplatten, der Kondensationsabzweigrohre oder der konischen Kondensationsrohre verbunden ist.

8. Wärmeabgebende Phasenwechselvorrichtung (10) nach Anspruch 4, **dadurch gekennzeichnet, dass** sie ferner mit dem Kondensatorteil (12) verbundene Kühllamellen umfasst.

9. Wärmeabgebende Phasenwechselvorrichtung nach Anspruch 8, **dadurch gekennzeichnet, dass** die Kühllamellen mit einer Außenfläche jeder der Kondensationsträgerplatten verlötet verbunden sind und die Kondensationskammer Wärme durch die Kühllamellen nach außen abstrahlt, um die Wärmequelle zu kühlen.

## Revendications

1. Dispositif de transfert thermique à changement de phase (10), comprenant un ensemble de changement de phase pourvu intérieurement d'un milieu d'échange thermique à changement de phase (20),
dans lequel l'ensemble de changement de phase comprend une partie évaporateur (11) et une partie condenseur (12), la partie évaporateur (11) contient une chambre d'évaporation, la partie condenseur (12) contient une chambre de condensation, une source de chaleur est en contact direct avec la chambre d'évaporation de telle sorte que le milieu d'échange thermique à changement de phase (20) dans la chambre d'évaporation peut absorber la chaleur de la source de chaleur, la chambre d'évaporation est en communication avec la chambre de condensation de sorte que le milieu d'échange thermique à changement de phase (20) dans la chambre d'évaporation peut transférer la chaleur vers la chambre de condensation, la chambre de condensation est structurée pour émettre de la chaleur vers l'extérieur de manière à refroidir la source de chaleur,
dans lequel la chambre d'évaporation est une chambre à paroi mince, le dispositif de transfert thermique à changement de phase étant **caractérisé en ce qu'**une pression de travail dans la chambre d'évaporation est une pression positive, et une surface de contact de la chambre d'évaporation en contact avec la source de chaleur peut générer une déformation élastique de manière à améliorer l'effet de contact entre la source de chaleur et la chambre d'évaporation.

2. Dispositif de transfert thermique à changement de phase (10) selon la revendication 1, **caractérisé en ce que** la chambre d'évaporation est une chambre plane adaptée à une structure plane de la source de chaleur, ou la chambre d'évaporation est une chambre incurvée adaptée à une structure de forme de surface incurvée de la source de chaleur, ou la chambre d'évaporation est une chambre polyédrique adaptée à de multiples surfaces de la source de chaleur, de manière à augmenter une surface de contact entre la source de chaleur et la chambre d'évaporation.

3. Dispositif de transfert thermique à changement de phase (10) selon la revendication 1, **caractérisé en ce que** la chambre de condensation est directement reliée à la chambre d'évaporation, ou est reliée à la chambre d'évaporation par une canalisation de liaison.

4. Dispositif de transfert thermique à changement de phase (10) selon l'une quelconque des revendications 1 à 3, **caractérisé en ce que** la partie de condenseur (12) comprend une pluralité de plaques de support de condensation, et la chambre de condensation comprend une chambre plane agencée de manière correspondante à l'intérieur de chacune des plaques de support de condensation ; ou la partie de condenseur (12) comprend une pluralité de conduites de dérivation de condensation, et la chambre de condensation comprend une chambre cylindrique agencée de manière correspondante à l'intérieur de chacune des conduites de dérivation de condensation ; ou la partie de condenseur (12) comprend une pluralité de conduites coniques de condensation, et la chambre de condensation comprend une chambre conique agencée de manière correspondante à l'intérieur de chacune des conduites coniques de condensation.

5. Dispositif de transfert thermique à changement de phase selon la revendication 4, **caractérisé en ce qu'**une pluralité de nervures, bosses ou ailettes sont agencées à l'intérieur de la partie évaporateur et/ou de la partie condenseur pour augmenter la portance en pression.

6. Dispositif de transfert thermique à changement de phase (10) selon la revendication 4, **caractérisé en ce que** la partie évaporateur (11) est munie d'un râtelier de montage, et la source de chaleur est reliée à la partie évaporateur (11) par l'intermédiaire du râtelier de montage.

7. Dispositif de transfert thermique à changement de phase (10) selon la revendication 4, **caractérisé en ce que** la partie de condenseur (12) comprend en outre une plaque supérieure de condensation, une chambre de condensation plane ou une chambre de condensation incurvée est formée à l'intérieur de la plaque supérieure de condensation, et la partie de chambre de condensation à l'intérieur de la plaque supérieure de condensation est en communication avec la partie de chambre de condensation à l'intérieur des plaques de support de condensation, des conduites de dérivation de condensation ou des conduites coniques de condensation.

8. Dispositif de transfert thermique à changement de phase (10) selon la revendication 4, **caractérisé en ce qu'**il comprend en outre des ailettes de refroidissement reliées à la partie de condenseur (12).

9. Dispositif de transfert thermique à changement de phase selon la revendication 8, **caractérisé en ce que** les ailettes de refroidissement sont reliées par brasage à une surface externe de chacune des plaques de support de condensation, et la chambre de condensation émet de la chaleur vers l'extérieur à travers les ailettes de refroidissement de manière à refroidir la source de chaleur.
